# FASCICULE DE BREVET EUROPEEN

(11) **EP 1 498 950 B1**
(45) Date de publication et mention de la délivrance du brevet: **31.12.2008**
(21) Numéro de dépôt: 04291722.9
(22) Date de dépôt: 07.07.2004
(51) Int. Cl.: H01L 23/66, H05K 9/00, H01P 1/04

(54) **Dispositif à circuits hybrides hyperfréquences à blindage par élèments(s) de contact élastiques(s)**
Vorrichtung für Mikrowellenhybridschaltungen mit federnden Kontaktelementen zur elektromagnetischen Abschirmung
Microwave hybrid circuit device with resilient contact shielding elements

(30) Priorité: 18.07.2003 FR 0308773
(43) Date de publication de la demande: 19.01.2005
(73) Titulaire: Alcatel Lucent, 75008 Paris (FR)
(72) Inventeur: Drevon, Claude, 31500 Toulouse (FR); Paillard, Mathieu, 31600 Muret (FR)
(74) Mandataire: Esselin, Sophie

(56) Documents cités:
- DE-C- 19 609 718
- US-A1- 2002 074 140
- PATENT ABSTRACTS OF JAPAN vol. 016, no. 079 (E-1171), 26 février 1992 (1992-02-26) -& JP 03 268396 A (FUJITSU LTD), 29 novembre 1991 (1991-11-29)
- PATENT ABSTRACTS OF JAPAN vol. 2003, no. 02, 5 février 2003 (2003-02-05) -& JP 2002 299875 A (SANYO ELECTRIC CO LTD;SANYO DENPA KOGYO KK), 11 octobre 2002 (2002-10-11)

## Description

L'invention concerne le domaine des dispositifs à circuits hybrides hyperfréquences.

Les circuits hybrides hyperfréquences présentant des gains toujours plus importants, ils doivent être installés dans des cavités isolées du point de vue hyperfréquence afin d'éviter des phénomènes de rebouclage et/ou d'oscillations. Les dispositifs (ou boîtiers), dans lesquels ils sont implantés, comprennent, à cet effet, un socle muni d'un mur périphérique externe et d'au moins un mur interne délimitant ensemble au moins deux cavités pouvant loger des circuits hybrides hyperfréquences, et un capot destiné à être solidarisé aux extrémités des murs de manière à assurer une fermeture hermétique des cavités et à établir un contact électrique de masse avec ces murs.

La solidarisation du capot aux murs extérieurs du socle, destinée à assurer l'herméticité de l'ensemble du circuit hybride, s'effectue par soudage, fréquemment par voie électrique à l'aide de molettes ou par laser.

Pour le mur interne la technique dite « tack-welding », spécifique de la fermeture « à la molette », permet d'assurer une herméticité hyperfréquence entre les différentes cavités.

Du fait de la position des murs internes, leur soudage s'effectue en aveugle. De plus, ce soudage nécessite une épaisseur de mur suffisante, d'une part, pour permettre le centrage du cordon, et d'autre part, pour éviter la projection de billes de soudure conductrices dans les cavités et donc sur les circuits hybrides. Cette (sur)épaisseur de mur est difficilement compatible avec la miniaturisation et le gain de poids recherchés dans les dispositifs hybrides. De plus, cette (sur)épaisseur de mur entraîne une augmentation de la longueur des connexions entre les sous-ensembles hyperfréquences installés dans les différentes cavités, laquelle nuit aux performances électriques recherchées dans les applications hyperfréquences.

Pour tenter de remédier à cet inconvénient, il a été proposé de solidariser le capot au(x) mur(s) interne(s) à l'aide d'une colle électriquement conductrice et compatible avec l'environnement hyperfréquence. Mais, ce type de colle présente une mauvaise tenue mécanique, incompatible avec les contraintes de vide et de cyclage thermique subies par les dispositifs hybrides.

Il a également été proposé de placer un matériau absorbant dans les cavités. Mais, cela ne résout que partiellement le problème et peut être préjudiciable à la fiabilité de certaines puces électroniques nues des circuits hybrides.

Il est connu du document :

PATENT ABSTRACTS OF JAPAN vol. 016, no. 079 (E-1171), 26 février 1992 (1992-02-26) - & JP 03 268396 A (FUJITSU LTD), 29 novembre 1991 (1991-11-29) un dispositif à circuits hybrides hyperfréquences comprenant un socle (2) muni d'un mur périphérique externe (21) et d'au moins un mur interne (21) délimitant ensemble au moins deux cavités propres à loger des circuits hybrides hyperfréquences (9), et un capot (3) propre à être solidarisé par une face interne à l'extrémité dudit mur périphérique de manière à assurer une fermeture hermétique des cavités et à établir un contact électrique avec ledit mur périphérique, ledit capot comportant des moyens de contact déformables et élastiques, solidarisés à sa face interne et agencés de manière à établir un contact électrique avec l'extrémité dudit mur interne (21).

Cependant aucune solution connue n'étant entièrement satisfaisante, l'invention a donc pour but de proposer une solution alternative destinée à améliorer la situation.

Elle propose à cet effet un dispositif à circuits hybrides hyperfréquences comprenant un socle muni d'un mur périphérique externe et d'au moins un mur interne délimitant ensemble au moins deux cavités pouvant recevoir des circuits hybrides hyperfréquences, et un capot destiné à être solidarisé par sa face interne à l'extrémité du mur périphérique de manière à assurer une fermeture hermétique des cavités et à établir un contact électrique avec ce mur périphérique.

Ce dispositif se caractérise par le fait que son capot comporte des moyens de contact déformables et élastiques, solidarisés à sa face interne, et agencés de manière à établir un contact électrique avec l'extrémité du mur interne.

Le dispositif selon l'invention peut comporter d'autres caractéristiques qui pourront être prises séparément ou en combinaison, et notamment :
- un socle comprenant plusieurs murs internes. Dans ce cas, les moyens de contact sont agencés de manière à établir un contact électrique avec l'extrémité de chaque mur interne,
- des mur périphérique et mur(s) interne(s) faisant saillie du socle,
- des moyens de contact agencés sous la forme d'au moins un élément
- rapporté, par exemple solidarisé-à la face interne du capot par soudage, et comportant une première partie solidarisée à la face interne du capot et prolongée par une seconde partie déformable et élastique. Par exemple, la première partie est en forme de bande et la seconde partie est constituée d'au moins deux lames déformables et élastiques (espacées d'une distance choisie en fonction de la bande de fréquence de fonctionnement desdits circuits hybrides hyperfréquences),
- chaque mur interne peut présenter une hauteur inférieure à celle du mur périphérique. Dans ce cas, la face interne du capot est sensiblement plane au moins dans la région située en regard des cavités. En variante, chaque mur interne peut présenter une hauteur sensiblement égale à la hauteur du mur périphérique. Dans ce cas, le capot est conformé de manière à définir au moins un logement propre à recevoir les moyens de contact. On peut même envisager que le capot comprenne autant de logements que d'éléments rapportés.

L'invention est particulièrement bien adaptée, bien que de façon non exclusive, aux circuits hybrides fonctionnant au moins jusque dans la bande de fréquence dite « bande K ».

On entend ici par bande K, aussi bien la bande Ku qui correspond, en réception, sensiblement à l'intervalle [13,7 GHz, 15,6 GHz] et, en émission, sensiblement à l'intervalle [10,7 GHz, 12,8 GHz], que la bande Ka qui correspond, en réception, sensiblement à l'intervalle [27,5 GHz, 30 GHz] et, en émission, sensiblement à l'intervalle [18,2 GHz, 20,2 GHz].

Le fonctionnement du dispositif peut-être étendu à des fréquences supérieures à la bande K en fonction de la distance entre les lames (ou doigts) qui constituent par exemple la partie déformable.

D'autres caractéristiques et avantages de l'invention apparaîtront à l'examen de la description détaillée ci-après, et des dessins annexés, sur lesquels :
- la figure 1 illustre de façon schématique, dans une vue du dessus, un exemple de socle de dispositif hybride selon l'invention,
- la figure 2 illustre de façon schématique, dans une vue en coupe transversale, un premier exemple de réalisation d'un dispositif hybride selon l'invention,
- la figure 3 illustre de façon schématique, dans une vue du dessus, un exemple de réalisation d'un élément de contact d'un dispositif hybride selon l'invention, et
- la figure 4 illustre de façon schématique, dans une vue en coupe transversale, un second exemple de réalisation d'un dispositif hybride selon l'invention.

Les dessins annexés pourront non seulement servir à compléter l'invention, mais aussi contribuer à sa définition, le cas échéant.

L'invention propose un dispositif à circuits hybrides hyperfréquences, également connu sous l'acronyme anglais MCM (pour « Multi Chip Module »).

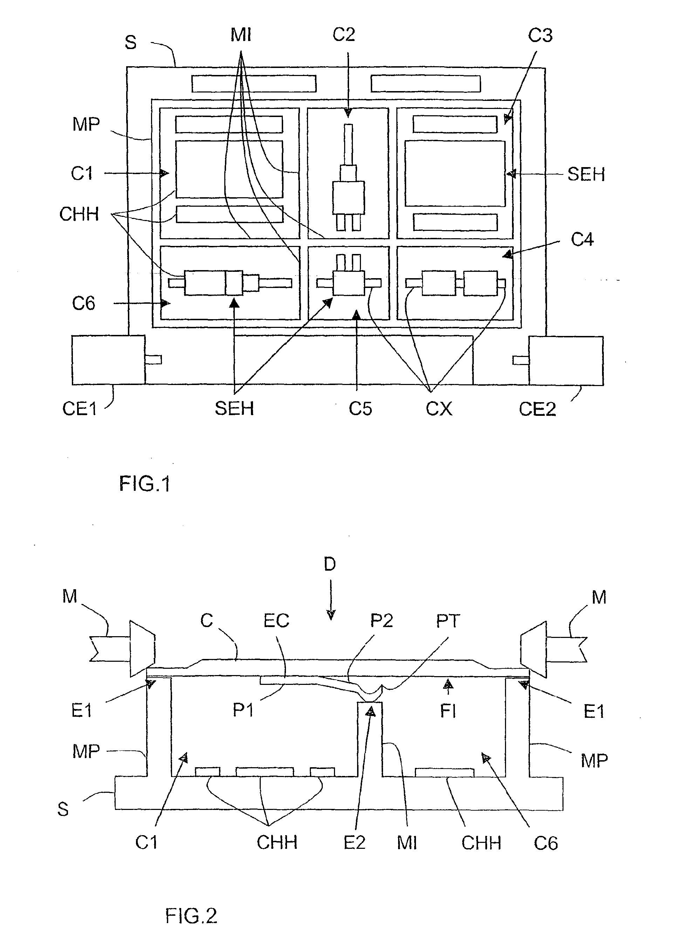

On se réfère tout d'abord aux figures 1 à 3 pour décrire un premier exemple de réalisation d'un dispositif (ou boîtier) hybride selon l'invention.

Ce dispositif D comporte tout d'abord un socle métallique ou céramique S (voir figure 1) muni d'un mur périphérique externe MP, se refermant sur lui-même afin de délimiter une enceinte, et d'au moins un mur interne MI, solidaire du mur périphérique MP et subdivisant l'enceinte en au moins deux cavités Ci. Ici, i est égal à six (6), mais il peut prendre n'importe quelle valeur supérieure ou égale à deux. En d'autres termes, dans l'exemple illustré sur la figure 1, le mur périphérique MP et les murs internes MI délimitent ensemble six cavités C1 à C6 dans lesquelles sont classiquement installés des sous-ensembles hybrides SEH constitués chacun d'au moins un circuit hybride hyperfréquence CHH. Comme illustré, certains sous-ensembles hybrides SEH peuvent être couplés les uns aux autres par l'intermédiaire de connexions CX passant au travers des murs internes MI. Par ailleurs, les sous-ensembles hybrides SEH sont couplés à des bornes de connexion externe CE1 et CE2, permettant le raccordement du dispositif hybride D à des équipements.

Les murs périphérique MP et interne(s) MI font saillie du socle S. Un tel agencement peut être notamment obtenu par usinage d'une plaque métallique, généralement en Kovar ®, ou par brasage de murs rapportés sur un support céramique multicouches ou non, ou par tout autre moyen permettant de réaliser des cavités Ci.

Afin de permettre le blindage hyperfréquence (ou l'isolation) des cavités Ci, le dispositif hybride D comprend un capot métallique C, généralement en Kovar ® (voir figure 2), destiné à être solidarisé par sa face interne FI à l'extrémité E1 du mur périphérique MP. Cette solidarisation s'effectue par exemple par soudage électrique à l'aide de molettes M. Cette technique permet d'assurer une fermeture hermétique de l'enceinte sur le plan de l'hyperfréquence, et d'établir un contact électrique de masse entre le capot C et le mur périphérique MP.

Afin d'assurer la fermeture hermétique des cavités Ci de l'enceinte, sur le plan de l'hyperfréquence, et d'établir un contact électrique de masse entre le capot C et les murs internes MP, le capot C comporte, sur sa face interne FI, des moyens de contact EC déformables et élastiques (et donc souples).

Plus précisément, comme illustré sur la figure 2, les moyens de contact EC sont préférentiellement solidarisés à la face interne FI du capot C, en des endroits choisis de manière à permettre l'établissement d'un contact électrique de masse, élastique, entre le capot C et chaque mur interne MI.

Par exemple, la solidarisation des moyens de contact EC au capot C s'effectue par soudage de type or-étain (Au-Sn) ou par soudure électrique par points.

Les moyens de contact EC sont préférentiellement agencés sous la forme d'au moins un élément rapporté comportant une première partie P1 solidarisée à la face interne FI du capot C et prolongée par une seconde partie P2 déformable et élastique. Cet élément rapporté est réalisé dans un matériau conducteur électriquement comme par exemple le cuivre béryllium.

Le capot C peut comporter soit un élément rapporté EC de ce type, soit plusieurs, afin de permettre le blindage hyperfréquence de chaque cavité Ci, ou seulement de certaines d'entre-elles.

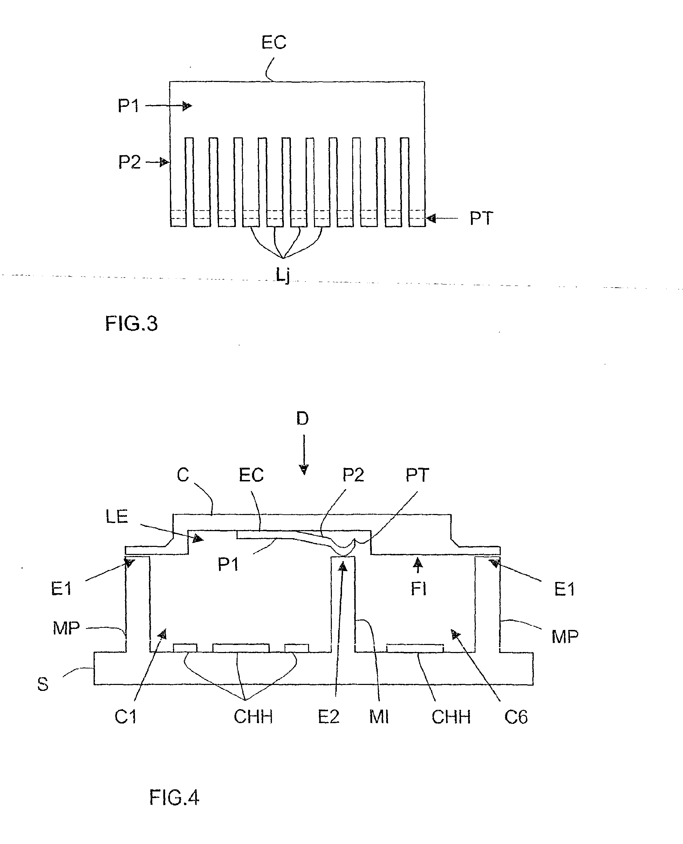

Comme cela est illustré sur la figure 3, la première partie P1 d'un élément rapporté EC est par exemple agencée sous la forme d'une bande rectangulaire plane et la seconde partie P2, qui prolonge cette bande, est par exemple agencée sous la forme d'au moins deux lames (ou doigts) Lj déformables et élastiques. Ici, j est égal à onze (11), mais il peut prendre n'importe quelle valeur supérieure ou égale à deux (2).

Les lames Lj sont particulièrement avantageuses car elles offrent une forte élasticité et supportent des déformations mécaniques importantes. Elles peuvent donc assurer un contact électrique de masse de qualité y compris dans des conditions de fonctionnement difficiles.

L'espacement entre lames adjacentes Lj est choisi en fonction de la bande de fréquence de fonctionnement des circuits hybrides hyperfréquences CHH. Il est en effet impératif que cet espacement interdise le passage des hyperfréquences si l'on souhaite isoler les cavités Ci les unes des autres, de façon efficace.

Le dispositif hybride D, selon l'invention, peut ainsi être utilisé au moins jusqu'en bande K (Ku comme Ka).

Comme cela est illustré sur la figure 2, chaque lame Lj prolonge la bande P1 selon un angle choisi en fonction, notamment, de la hauteur du mur interne MI et de la forme du capot C. Par ailleurs, la partie terminale PT de chaque lame Lj, opposée à la bande P1, est préférentiellement conformée de manière à définir une espèce de cuvette dont le fond est au contact de l'extrémité E2 du mur interne MI concerné. Cela permet d'obtenir un contact entre la lame Lj et le mur interne MI de nature à minimiser les risques d'abrasion pouvant intervenir lors des mouvements relatifs entre la lame Lj et le mur interne MI.

Dans l'exemple de réalisation illustré sur la figure 2, les murs internes MI présentent une hauteur inférieure à la hauteur du mur périphérique MP et la face interne FI du capot C est sensiblement plane au moins dans la région qui est située en regard des cavités Ci. Mais, il peut en être autrement.

L'invention peut en effet s'appliquer, également, à des socles S traditionnels dans lesquels la hauteur des murs internes MI est sensiblement égale à celle du mur périphérique MP. Dans ce cas, comme illustré sur la figure 4, le capot C doit être conformé de manière à définir au moins un logement LE permettant de recevoir les moyens de contact EC.

Lorsque les moyens de contact sont agencés sous la forme de plusieurs éléments rapportés EC, du type de celui illustré sur la figure 3, le capot C peut soit comprendre un unique logement LE recevant tous les éléments rapportés EC, soit plusieurs logements LE recevant chacun au moins un élément rapporté.

Le ou les logements LE peuvent être obtenus par usinage chimique d'une plaque métallique définissant le capot C, ou par tout autre moyen approprié.

En raison de la force de réaction exercée par les moyens de contact EC sur le capot C, du fait de leur élasticité, il est préférable de maintenir le capot C étroitement pressé contre les extrémités E1 du mur périphérique MP pendant toute la phase de solidarisation.

L'invention ne se limite pas aux modes de réalisation de dispositif hybride décrits ci-avant, seulement à titre d'exemple, mais elle englobe toutes les variantes que pourra envisager l'homme de l'art dans le cadre des revendications ci-après.

Ainsi, dans ce qui précède on a décrit des moyens de contact élastiques et déformables agencés sous la forme de première et seconde parties, cette dernière étant constituée de lames (ou doigts). Mais, tout autre agencement des moyens de contact peut être envisagé dès lors qu'il leur assure une élasticité et une déformabilité permettant un contact électrique entre le capot et le(s) mur(s) interne(s), tout en assurant le blindage hyperfréquence des cavités.

## Revendications

1. Dispositif (D) à circuits hybrides hyperfréquences (CHH) comprenant un socle (S) muni d'un mur périphérique externe (MP) et d'au moins un mur interne (MI) délimitant ensemble au moins deux cavités (Ci) propres à loger des circuits hybrides hyperfréquences (CHH), et un capot (C) propre à être solidarisé par une face interne (FI) à l'extrémité dudit mur périphérique (MP) de manière à assurer une fermeture hermétique des cavités (Ci) et à établir un contact électrique avec ledit mur périphérique (MP), ledit capot (C) comportant des moyens de contact (EC) déformables et élastiques, solidarisés à sa face interne (FI), et agencés de manière à établir un contact électrique avec l'extrémité dudit mur interne (MI), **caractérisé en ce que** lesdits moyens de contact (EC) sont agencés sous la forme d'au moins un élément rapporté comportant une première partie (P1) solidarisée à ladite face interne (FI) du capot (C) et prolongée par une seconde partie (P2) déformable et élastique et **en ce que**, ladite première partie (P1) est en forme de bande et ladite seconde partie (P2) est constituée d'au moins deux lames (L) déformables et élastiques.

2. Dispositif selon la revendication 1, **caractérisé en ce que** ledit socle (S) comprend plusieurs murs internes (MI) et **en ce que** lesdits moyens de contact (EC) sont agencés de manière à établir un contact électrique avec l'extrémité de chaque mur interne (MI).

3. Dispositif selon l'une des revendications 1 et 2, **caractérisé en ce que** lesdits mur périphérique (MP) et mur(s) interne(s) (MI) font saillie dudit socle (S).

4. Dispositif selon la revendication 1, **caractérisé en ce que** lesdites lames (L) sont espacées d'une distance choisie en fonction de la bande de fréquence de fonctionnement desdits circuits hybrides hyperfréquences (CHH).

5. Dispositif selon l'une des revendications 1 à 4, **caractérisé en ce que** chaque lame (L) comprend une partie terminale (PT) conformé de manière à définir une cuvette dont un fond est destiné à contacter l'extrémité du mur interne (MI).

6. Dispositif selon l'une des revendications 1 à 5, **caractérisé en ce que** lesdits moyens de contact (EC) sont solidarisés à ladite face interne (FI) du capot (C).

7. Dispositif selon l'une des revendications 1 à 6, **caractérisé en ce que** chaque mur interne (MI) présente une hauteur inférieure à la hauteur dudit mur périphérique (MP), et **en ce que** ladite face interne (FI) du capot (C) est sensiblement plane au moins dans une région en regard desdites cavités (Ci).

8. Dispositif selon l'une des revendications 1 à 6, **caractérisé en ce que** chaque mur interne (MI) présente une hauteur sensiblement égale à la hauteur dudit mur périphérique (MP), et **en ce que** ledit capot (C) est conformé de manière à définir au moins un logement (LE) propre à recevoir lesdits moyens de contact (EC).

9. Dispositif selon la combinaison des revendications 1 et 8, **caractérisé en ce que** ledit capot (C) comprend autant de logements (LE) que d'éléments (EC).

10. Utilisation du dispositif (D) selon l'une des revendications précédentes dans des bandes de fréquence allant au moins jusque dans une bande de fréquence dite « bande K ».

## Claims

1. Hybrid microwave circuit (CHH) device (D) comprising a base (S) provided with an external peripheral wall (MP) and at least one internal wall (MI) together delimiting at least two cavities (Ci) adapted to accommodate hybrid microwave circuits (CHH) and a cover (C) adapted to have an internal face (FI) fastened to the edge of said peripheral wall (MP) to provide a hermetic seal of the cavities (Ci) and to establish an electrical contact with said peripheral wall (MP), said cover (C) comprising deformable and elastic contact means (EC) fastened to its internal face (FI) and adapted to establish an electrical contact with the edge of said internal wall (MI), **characterized in that** said contact means (EC) take the form of at least one attached member comprising a first portion (P1) fastened to said internal face (FI) of the cover (C) and extended by a deformable and elastic second portion (P2), and **in that** said first portion (P1) takes the form of a strip and said second portion (P2) comprises at least two deformable and elastic blades (L).

2. Device according to Claim 1, **characterized in that** said base (S) comprises a plurality of internal walls (MI) and **in that** said contact means (EC) are adapted to establish an electrical contact with the edge of each internal wall (MI).

3. Device according to either of Claims 1 and 2, **characterized in that** said peripheral wall (MP) and said internal wall or walls (MI) project from said base (S).

4. Device according to Claim 1, **characterized in that** said blades (L) are spaced by a distance chosen as a function of the operating frequency band of said hybrid microwave circuits (CHH).

5. Device according to any of Claims 1 to 4, **characterized in that** each blade (L) has a terminal portion (PT) conformed to define a cup having a bottom adapted to come into contact with the edge of the internal wall (MI).

6. Device according to any of Claims 1 to 5, **characterized in that** said contact means (EC) are fastened to said internal face (FI) of the cover (C) .

7. Device according to any of Claims 1 to 6, **characterized in that** each internal wall (MI) is lower than said peripheral wall (MP) and **in that** said internal face (FI) of the cover (C) is substantially plane at least in one region facing said cavities (Ci).

8. Device according to any of Claims 1 to 6, **characterized in that** the height of each internal wall (MI) is substantially equal to the height of said peripheral wall (MP) and **in that** said cover (C) is conformed to define at least one housing (LE) adapted to receive said contact means (EC).

9. Device according to the combination of Claims 1 and 8, **characterized in that** said cover (C) comprises the same number of housings (LE) and members (EC).

10. Use of the device (D) according to any one of the preceding claims in frequency bands ranging at least up to a frequency band known as the "K band".

## Patentansprüche

1. Vorrichtung (D) mit hybriden Mikrowellenschaltungen (CHH), die einen Sockel (S), der mit einer äußeren Umfangswand (MP) und mit mindestens einer Innenwand (MI) versehen ist, welche zusammen mindestens zwei Hohlräume (Ci) begrenzen, die hybride Mikrowellenschaltungen (CHH) aufnehmen können, und einen Deckel (C) aufweist, der über eine Innenseite (FI) fest mit dem Ende der Umfangswand (MP) verbunden werden kann, um ein hermetisches Verschließen der Hohlräume (Ci) zu gewährleisten und einen elektrischen Kontakt mit der Umfangswand (MP) herzustellen, wobei der Deckel (C) verformbare und elastische Kontaktmittel (EC) aufweist, die fest mit seiner Innenseite (FI) verbunden und so angeordnet sind, dass sie einen elektrischen Kontakt mit dem Ende der Innenwand (MI) herstellen, **dadurch gekennzeichnet, dass** die Kontaktmittel (EC) in Form mindestens eines angesetzten Elements ausgebildet sind, das einen ersten Teil (P1) aufweist, der fest mit der Innenseite (FI) des Deckels (C) verbunden ist und von einem zweiten verformbaren und elastischen Teil (P2) verlängert wird, und dass der erste Teil (P1) die Form eines Bands hat und der zweite Teil (P2) aus mindestens zwei verformbaren und elastischen Lamellen (L) besteht.

2. Vorrichtung nach Anspruch 1, **dadurch gekennzeichnet, dass** der Sockel (S) mehrere Innenwände (MI) aufweist und dass die Kontaktmittel (EC) so angeordnet sind, dass sie einen elektrischen Kontakt mit dem Ende jeder Innenwand (MI) herstellen.

3. Vorrichtung nach einem der Ansprüche 1 und 2, **dadurch gekennzeichnet, dass** die Umfangswand (MP) und die Innenwand (Innenwände) (MI) vom Sockel (S) vorstehen.

4. Vorrichtung nach Anspruch 1, **dadurch gekennzeichnet, dass** die Lamellen (L) einen Abstand zueinander haben, der in Abhängigkeit vom Betriebsfrequenzband der hybriden Mikrowellenschaltungen (CHH) ausgewählt wird.

5. Vorrichtung nach einem der Ansprüche 1 bis 4, **dadurch gekennzeichnet, dass** jede Lamelle (L) einen Endbereich (PT) aufweist, der so ausgebildet ist, dass er eine Mulde definiert, von der ein Boden dazu bestimmt ist, das Ende der Innenwand (MI) zu kontaktieren.

6. Vorrichtung nach einem der Ansprüche 1 bis 5, **dadurch gekennzeichnet, dass** die Kontaktmittel (EC) fest mit der Innenseite (FI) des Deckels (C) verbunden sind.

7. Vorrichtung nach einem der Ansprüche 1 bis 6, **dadurch gekennzeichnet, dass** jede Innenwand (MI) eine geringere Höhe als die Höhe der Umfangswand (MP) hat und dass die Innenseite (FI) des Deckels (C) mindestens in einem Bereich gegenüber den Hohlräumen (Ci) im Wesentlichen eben ist.

8. Vorrichtung nach einem der Ansprüche 1 bis 6, **dadurch gekennzeichnet, dass** jede Innenwand (MI) eine Höhe im Wesentlichen gleich der Höhe der Umfangswand (MP) hat und dass der Deckel (C) so ausgebildet ist, dass er mindestens eine Aufnahme (LE) definiert, die die Kontaktmittel (EC) aufnehmen kann.

9. Vorrichtung gemäß der Kombination der Ansprüche 1 und 8, **dadurch gekennzeichnet, dass** der Deckel (C) ebenso viele Aufnahmen (LE) wie Elemente (EC) aufweist.

10. Verwendung der Vorrichtung (D) nach einem der vorhergehenden Ansprüche in Frequenzbändern, die bis mindestens zu einem "K-Band" genannten Frequenzband gehen.
